# EUROPEAN PATENT APPLICATION

(11) **EP 2 793 037 A1**
(43) Date of publication of application: **22.10.2014**
(21) Application number: 13305500.4
(22) Date of filing: 17.04.2013
(51) Int. Cl.: G01R 23/02, G01R 31/28, H03L 7/02, H03L 7/18

(54) **Digital frequency meter**

(71) Applicant: Asahi Kasei Microdevices Corporation, Tokyo 101-8101 (JP)
(72) Inventor: Charpentier, Sébastien, 14460 Colombelles (FR); Canard, David, 14460 Colombelles (FR)
(74) Representative: Cabinet Plasseraud

(57) **Abstract**

A digital frequency meter comprises a clock comparator (1), a loop filter (2) and a frequency converter (3) connected so as to form a closed-loop system. The loop filter is of proportional-integral type and outputs a digital signal which is used as division factor within the frequency converter. The frequency measurement result is based on said digital signal. Such digital frequency meter can be obtained by re-wiring components pertaining to a phase-locked loop (PLL) device, and may be used for testing a voltage-controlled oscillator of the PLL device itself.

## Description

The invention relates to a digital frequency meter and a method for measuring a signal frequency. It may be applied to testing oscillators of phase-locked loop devices.

### -- BACKGROUND OF THE INVENTION --

Numerous electric or integrated electronic circuits include frequency synthesizers. In particular, they may include voltage-controlled oscillators (VCOs) and/or phase-locked loop (PLL) devices.

Then, an important issue is testing the frequency synthesizer of a circuit in a rapid, efficient and low-cost manner, whatever the frequency range. But using an external tester as commonly implemented is time-consuming and expensive as a consequence. Also using such tester may lead to poor yield coverage with respect to frequency synthesizers with multiple frequency ranges.

Then, an object of the present invention consists in alleviating at least one of the preceding drawbacks of the existing methods for testing frequency synthesizers.

### -- SUMMARY OF THE INVENTION --

For meeting this object or others, a first aspect of the invention proposes a digital frequency meter which comprises:
- a clock comparator, having itself:
   a first comparator input intended for receiving a reference signal which has a reference frequency;
   a second comparator input for receiving a frequency-converted signal; and
   a comparator output adapted for outputting an error signal which is representative of a phase difference existing between the reference signal and the frequency-converted signal;
- a loop filter of proportional-integral type, having itself:
   a filter input connected to the comparator output; and
   a filter output adapted for outputting a digital signal which corresponds to a time-filtering of the error signal as received at the filter input; and
- a frequency converter, having itself:
   a first converter input intended for receiving a measurement signal which has a test frequency to be measured;
   a second converter input connected to the filter output; and
   a converter output which is adapted for outputting the frequency-converted signal based on the measurement signal as received at the first converter input, by dividing the test frequency by the digital signal as received at the second converter input, this converter output being connected to the second comparator input.

The filter output is also connected to an output of the digital frequency meter. Thus, a measurement result for the test frequency is based on the digital signal which is outputted by the loop filter.

So, a digital frequency meter according to the invention is based on a closed-loop implementation, which provides rapid convergence of the measurement result. The measurement duration can thus be very short, so that it does not cause significant test cost. In addition, the invention frequency meter is comprised of standard components, so that it is also low-cost with respect to the hardware implemented.

Because of the proportional-integral type of the loop filter, the digital signal results from both an accumulation and instant-response behaviour. The accumulation goes on until the closed loop converges towards a steady state, then leading to the digital signal equalling the ratio of the test frequency over the reference frequency. The instant-response behaviour of the loop filter provides faster convergence and ensures real-time variation of the measurement result for matching possible drift of the test frequency.

In some improvements of the invention, the digital frequency meter may further comprise an averaging module, which is arranged so that the filter output is connected to the output of the digital frequency meter using this averaging module. Thus, the invention frequency meter can supply a meaningful measurement result even if the test frequency varies rapidly over time, for example due to uncontrolled changes of external parameters.

When the digital signal possibly has an integer part and a fractional part, the invention frequency meter may further comprise a splitter, a sigma-delta modulator and an adder, for transforming the digital signal into a format which better suits the frequency converter operation. To this purpose, the splitter may be connected for receiving at input the digital signal from the filter output, and transmitting to the sigma-delta modulator and the adder respectively the fractional and integer parts of the digital signal. Then, the adder may itself be connected for receiving both the integer part and a modulated instant value which is produced by the sigma-delta modulator based on the fractional part, and for transmitting a sum result of these integer part and instant value to the second converter input. In this way, the frequency converter is fed with an instant digital signal which is integer, thus adapted for being used directly as frequency division factor. This instant digital signal is further made varying by the sigma-delta modulator, so that it matches in average over time the digital signal as actually outputted by the loop filter.

In analog embodiments of the invention, the clock comparator may comprise a phase frequency detector and a charge pump unit serially connected. Then, the loop filter may comprise itself a resistor and a capacitor which are serially connected between an output of the charge pump unit and a voltage reference terminal, and may further comprise an analog-to-digital converter which is also connected to the output of the charge pump unit. The serially connected resistor and capacitor form a simple structure for the proportional-integral loop filter, and the analog-to-digital converter produces the digital signal so that it matches the total voltage which exists over both the resistor and the capacitor.

Alternatively, in digital embodiments of the invention, the clock comparator may comprise a phase frequency detector and a time-to-digital converter which are serially connected. Then, the loop filter may comprise itself a digital proportional-integral filter.

Preferably, the digital frequency meter of the invention may be comprised within an in-chip circuitry.

In further preferred invention embodiments, the clock comparator, the loop filter and the frequency converter may also pertain to a phase-locked loop device. Then, these components are connected either for operation of the digital frequency meter or for PLL operation, in accordance with an operation selection command. The PLL device of such invention embodiments further comprises:
- an extra loop filter of digital low-pass type, which is connected at input to the filter output of the loop filter of proportional-integral type;
- a digital-to-analog converter, which is connected at input to an output of the extra loop filter; and
- a voltage-controlled oscillator (VCO) having itself:
   an analog input, which is connected for receiving a direct voltage produced from the digital-to-analog converter; and
   a VCO output adapted for outputting a VCO signal having a frequency which varies as a continuous function of the direct voltage, and the VCO output being connected to the first converter input at least for the PLL operation.
The PLL device is adapted so that during the PLL operation, the connection from the filter output of the loop filter to the second converter input is disabled and replaced by an input path which is adapted for forcing a division factor value at the second converter input. Therefore, within the circuitry, the same clock comparator, loop filter and frequency converter are common to the frequency meter operation and the PLL operation. Only re-wiring of these components is necessary between both operations, so that the invention provides the frequency meter function without extra-cost for a circuit which already comprises a PLL device.

Possibly, the optional averaging module may be a low-pass filter which also pertains to the PLL device, and is connected downstream the loop filter during the PLL operation.

In particular, the frequency meter function which is thus obtained may be used for testing the VCO of the PLL device itself. For this purpose, the VCO output may be connected to the first converter input also for the digital frequency meter operation, so that the VCO signal forms the measurement signal and the measurement result of the digital frequency meter operation relates to the frequency of this VCO signal. In addition, the digital frequency meter may be further adapted for forcing the direct voltage which is received at the analog input of the VCO to a constant value, during the digital frequency meter operation. Thus, the test frequency is that of the VCO when fed with the constant value for the direct voltage.

Possibly, the VCO may be provided with a digitally-controlled capacitor rank suitable for selecting one frequency range based on a code value, among a plurality of frequency ranges available. Then, the digital frequency meter may be further adapted for supplying the capacitor rank with successive code values, respectively for several successive digital frequency meter operations. Automatic testing of the VCO can thus be performed for several or all of its frequency ranges.

A second aspect of the invention proposes a method for measuring a test frequency of a measurement signal, which method comprises the following steps:
/i/ providing a PLL device which comprises at least a clock comparator, a loop filter of proportional-integral type and a frequency converter, which are connected for PLL operation;
/ii/ wiring these clock comparator, loop filter and frequency converter so as to form a digital frequency meter in accordance with the first invention aspect;
/iii/ inputting the measurement signal into the first converter input so as to obtain a measurement result which relates to the test frequency; and
/iv/ re-wiring the clock comparator, loop filter and frequency converter back for the PLL operation.

When the frequency of a voltage-controlled oscillator which pertains to the PLL device is to be measured, the VCO output is connected during at least step /iii/ to the first converter input. Thus, the frequency of the VCO signal is the test frequency while a direct voltage which is fed into the VCO is forced to a constant value.

These and other features of the invention will be now described with reference to the appended figures, which relate to preferred but not-limiting embodiments of the invention.

### -- BRIEF DESCRIPTION OF THE DRAWINGS --

Figure 1 is a block diagram of a digital frequency meter according to the invention;
Figure 2 is an analog-equivalent for filters implemented in the digital frequency meter of Figure 1;
Figure 3a is a block diagram of a circuitry embodying alternatively a digital frequency meter according to Figure 1 and a PLL device; and
Figures 3b and 3c correspond to Figure 3a, respectively for a digital frequency meter operation and a PLL operation.

Same reference numbers which are indicated in different ones of these figures denote identical elements of elements with identical function. In addition, components with well-known functions and operation but not connected directly to the invention features are not described in detail.

### -- DETAILED DESCRIPTION OF THE INVENTION --

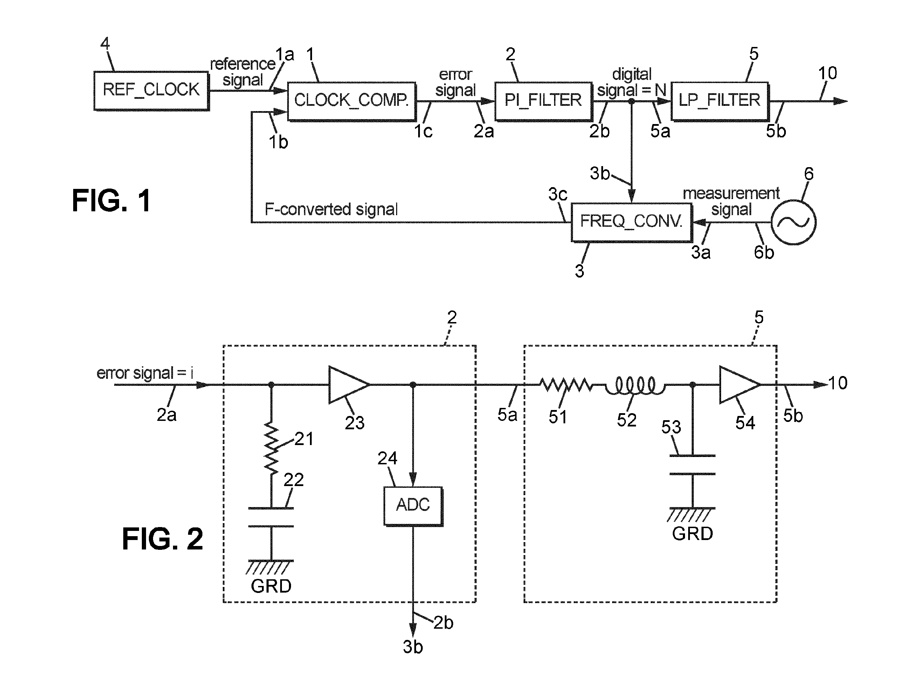

Referring to Figure 1, the reference numbers indicated therein have the following meanings:
1 clock comparator, denoted CLOCK_COMP., with inputs respectively labelled 1a and 1b, and output 1c
2 loop filter, denoted PI_FILTER, with input 2a and output 2b
3 frequency converter, denoted FREQ_CONV., with inputs respectively labelled 3a and 3b, and output 3c
4 reference clock, denoted REF_CLOCK, for delivering a reference signal which has a reference frequency
5 optional filter, denoted LP_FILTER, with input 5a and output 5b
6 frequency synthesizer with output 6b, for delivering a measurement signal which has an unknown frequency, denoted test frequency 10 output of the digital frequency meter

The reference clock 4 may be of any type, provided that its reference frequency it accurately known. It is connected so as to feed the input 1a of the clock comparator 1 with the reference signal.

The clock comparator 1 produces at output 1c an error signal which is representative of a phase difference between the reference signal received at the input 1a and another periodic signal which is fed into the other comparator input 1b.

The loop filter 2 is of the type proportional-integral, as described later on with reference to Figure 2. It produces at output 2b a digital signal which is based on the error signal fed into input 2a. The error signal may be of analog or digital type, depending on the type of the clock comparator 1 and loop filter 2 actually used. However, the signal outputted by the loop filter 2 is digital for implementing the present invention.

The frequency converter 3 may be a frequency divider arranged for producing at output 3c an F-converted signal which is based on the measurement signal received at input 3a. The input 3b of the frequency converter 3 is dedicated for receiving a non-zero division factor denoted N, so that the F-converted signal results from the measurement signal by N-dividing the test frequency of this latter. The F-converted signal thus obtained is fed into the input 1b of the clock comparator 1.

Thus, the clock comparator 1, the loop filter 2 and the frequency converter 3 form a closed loop with feedback operation. Externally-entered contents are the reference frequency and the test frequency. Because of the convergence which is provided in operation by the closed-loop structure, and because the digital signal is fed at input 3b of the frequency converter 3, the digital signal after convergence has been reached is the ratio of the test frequency over the reference frequency. It forms the frequency measurement result which is forwarded to the frequency meter output 10. Thus, the test frequency equals the reference frequency multiplied by the digital signal as this latter results from the convergence operation of the closed-loop structure.

The filter 5 is a low-pass filter, which is optional. It may be implemented for time-averaging the digital signal outputted by the loop filter 2. In case it is not used, the output 2b of the loop filter 2 may be connected directly to the frequency meter output 10. The filter 5 is preferably of digital type. Possibly, it may be replaced with any time-averaging module known in the art.

As it is well-known from the Man skilled in the art, any filter can be analyzed using its pulse response. Then, a proportional-integral filter is defined as a filter with a Laplace-transform of its pulse response which has one pole and one zero value.

Figure 2 is an electric diagram which is analog-equivalent to the loop filter 2 and the optional filter 5. The error signal which is fed into the input 2a of the loop filter 2 may be an instant current which is denoted i. Such error signal current may be actually produced by the clock comparator 1 when this latter is of analog type. In such case, the clock comparator 1 may be comprised of a phase frequency comparator and a charge pump unit connected downstream the phase frequency comparator. Then, current i may be produced at output by the charge pump unit.

For such analog embodiment of the invention, the loop filter 2 may be comprised of a resistor 21 and a capacitor 22 which are serially connected between the input 2a and a voltage reference terminal denoted GRD. Then, the loop filter 2 produces a voltage between the input 2a and the terminal GRD, in response to the error signal current i. This voltage is converted into the digital signal using an analog-to-digital converter 24, denoted ADC. Reference number 23 denotes a buffer arranged for ensuring that the whole error signal current i is actually fed into the branch which includes the resistor 21 and the capacitor 22.

The optional filter 5 may be a second order low-pass filter. It may be analog-equivalent to a resistor 51, an inductor 52 and a capacitor 53 which are serially connected between the input 5a and the voltage reference terminal GRD. The time-filtered signal delivered at output 5b is the voltage across the capacitor 53. Reference number 54 denotes another buffer, and another analog-to-digital converter (not shown) may be arranged at the output 5b for delivering a digital time-averaged result for the frequency measurement.

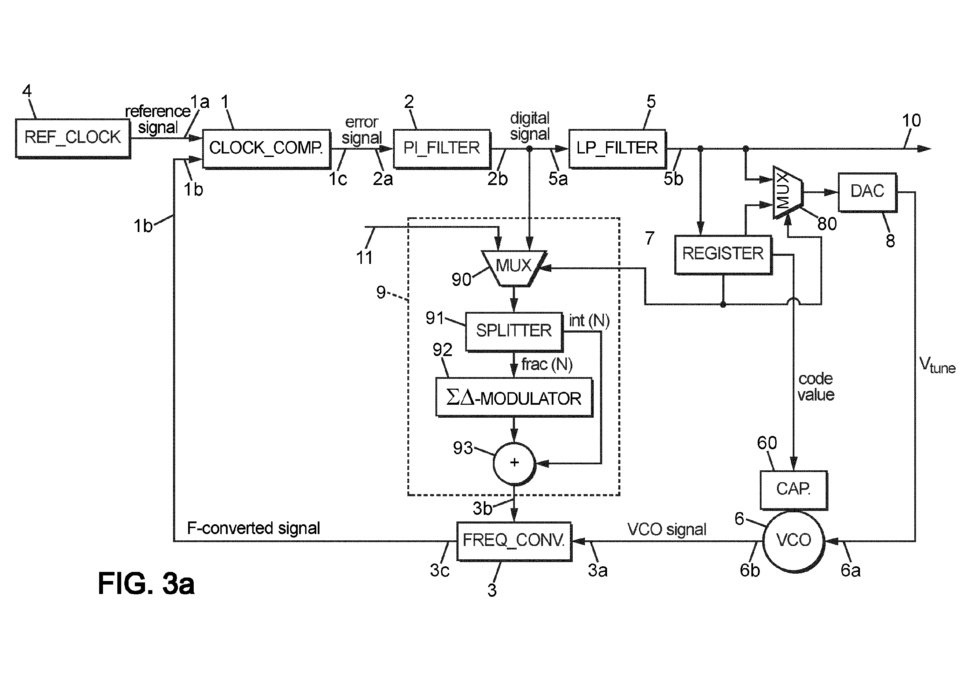

Figures 3a to 3c relate to a preferred implementation of the invention within a phase-locked loop (PLL) device. Such implementation allows testing a voltage-controlled oscillator (VCO) used in the PLL device, without requiring an external tester. The digital frequency meter is simply obtained by temporarily using some of the components of the PLL device according to the frequency meter operation, and then recovering the PLL operation. The additional reference numbers indicated in Figure 3a have the following meanings:
- 7: register dedicated to operation selection control and frequency meter operation
- 6a: a analog input of a voltage-controlled oscillator (VCO) used in the PLL device, and also forming the frequency synthesizer 6 to be tested
- 60: digitally-controlled capacitor rank of the VCO, denoted CAP., which sets the frequency range of the VCO based on a code value
- 8: digital-to-analog converter
- 9: modified connection from the filter output 2b to the second converter input 3b
- 11: input dedicated to the PLL operation, for entering a value of the frequency division factor
- 80 and 90: multiplexers, denoted MUX, for switching the PLL device between the functional mode, namely the frequency synthesizer operation, and the test mode, namely the frequency meter operation
- 91: digital splitter, which is adapted for separating an integer part from a fractional part within a digital number received at input
- 92: sigma-delta modulator, denoted ΣΔ-MODULATOR, and arranged for producing a modulated instant value based on the fractional part transmitted from the splitter 91
- 93: adder, arranged for adding the integer part transmitted from the splitter 91, to the instant value as produced by the sigma-delta modulator 92

The output of the adder 93 is connected to the input 3b of the frequency converter 3. In this manner, non-integer digital values which are inputted at the entrance of the connection 9, are converted into suitable format for being used as the division factor N within the frequency converter 3. For this reason, the integer and fractional parts separated by the splitter 91 are respectively denoted int(N) and frac(N).

As commonly known, the VCO 6 produces at output 6b a VCO signal which has a frequency determined by a direct voltage Vₜᵤₙₑ applied to the analog input 6a. This frequency varies as a continuous function of the Vtune-voltage, within a frequency range which is determined by the code value sent to the capacitor rank 60. Changing the code value allows switching between several frequency ranges which are available alternatively.

The low-pass filter 5 may pertain initially to the PLL device. Thus it participates to the PLL operation by forming the usual PLL loop filter together with the proportional-integral filter 2. Advantageously, the low-pass filter 5 of the PLL device is used again for the frequency meter operation.

Although the frequency meter operation could be used for measuring the frequency of any externally-supplied signal, the following description relates to measuring the frequency of the VCO. Then, the signal which is outputted by the VCO 6, denoted VCO signal, is the measurement signal previously introduced.

The register 7 produces an operation selection command which is transmitted to both multiplexers 80 and 90. Switching of the multiplexers 80 and 90 produces suitable re-wiring for swapping the PLL operation for the frequency meter operation, and back to the initial operation if desired.

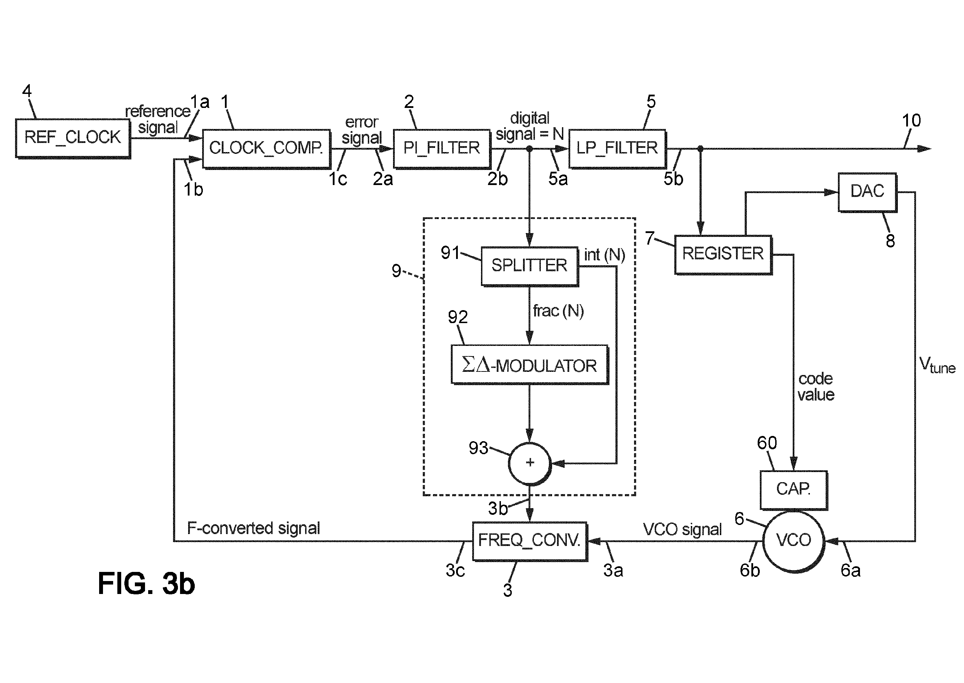

Figure 3b corresponds to Figure 3a when the frequency meter operation is selected. To this end, the register 7 controls the multiplexer 80 so that the digital-to-analog converter 8 receives at input a fixed digital value. This fixed digital value may be produced by the register 7 itself or any other suitable means. As a result, the Vₜᵤₙₑ-voltage is maintained constant so that the connection from the low-pass filter 5 to the analog input 6a of the VCO 6 is no longer active as a feedback connection. The register 7 controls simultaneously the multiplexer 90 so that the digital signal outputted by the loop filter 2 is transmitted by the connection 9 to the converter input 3b. Then, the operation is that described before with reference to Figure 1, and provides at output 10 a measurement result which relates to the frequency of the VCO signal. The register 7 may also select the code value to be sent to the capacitor rank 60, for testing the desired frequency range. Scanning of several or all frequency ranges which are available for the VCO 6 may further be controlled by the register 7, by varying the code value selected over time. Automatic scanning is also possible if the register 7 is capable of testing convergence hit of the time-averaged digital signal as existing at output 5b of the low-pass filter 5.

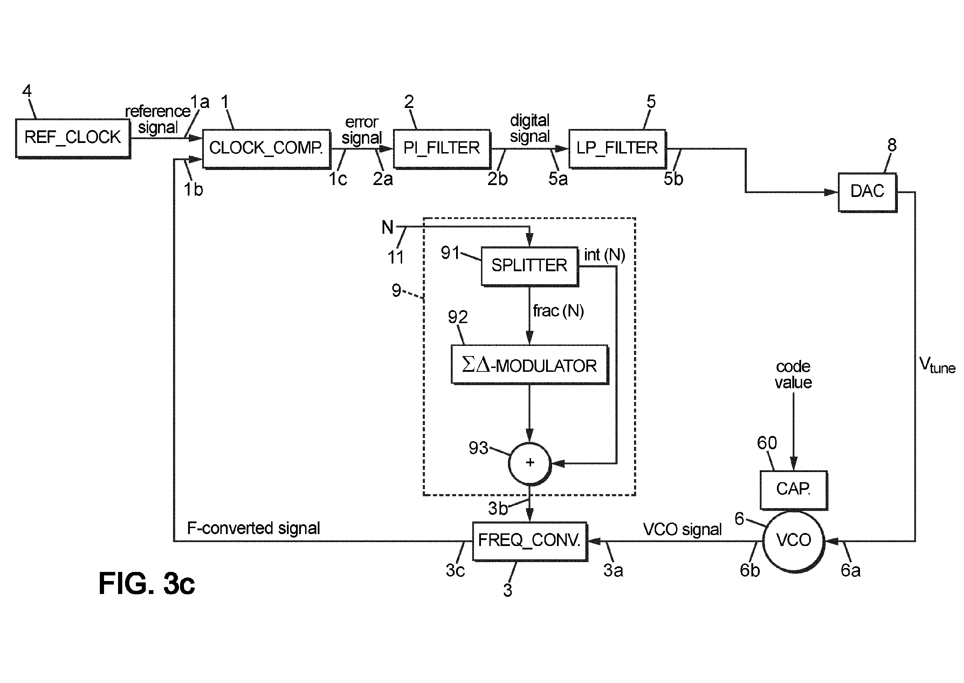

Figure 3c corresponds to Figure 3a when the PLL operation is selected. The register 7 then controls the multiplexer 80 so that the time-filtered digital signal produced by the low-pass filter 5 is transmitted to the digital-to-analog converter 8. As a result, the Vₜᵤₙₑ-voltage now acts as a feedback parameter from the low-pass filter 5 to the analog input 6a of the VCO 6. The register 7 controls simultaneously the multiplexer 90 so that the digital signal outputted by the loop filter 2 is no longer transmitted by the connection 9 to the converter input 3b. Instead of such loop transmission, the multiplexer 90 is controlled for transmitting a fixed value of the division factor N, which is entered from external source at the input 11. Thus, the resulting operation is the usual one for a PLL-based frequency synthesizer.

Obviously, the invention may be implemented while introducing changes with respect to the above detailed description. In particular, the register 7 and the multiplexers 80 and 90 which have been used for re-wiring suitably between the frequency meter operation and the PLL operation, may be replaced with other equivalent systems.

It is also reminded that the clock comparator 1 and the loop filter 2 may be selected so that the intermediate signal error is of analog type, while the overall operation remains unchanged.

Also, even when the invention digital frequency meter is obtained by re-wiring a PLL device, its use is not limited to testing the VCO of the same PLL device, but it may be used too for testing any frequency synthesizer external to the PLL device.

## Claims

1. Digital frequency meter comprising:
- a clock comparator (1), having itself:
a first comparator input (1a) intended for receiving a reference signal having a reference frequency;
a second comparator input (1b) for receiving a frequency-converted signal; and
a comparator output (1c) adapted for outputting an error signal representative of a phase difference existing between the reference signal and the frequency-converted signal;
- a loop filter (2) of proportional-integral type, having itself:
a filter input (2a) connected to the comparator output (1c); and
a filter output (2b) adapted for outputting a digital signal corresponding to a time-filtering of the error signal as received at the filter input; and
- a frequency converter (3), having itself:
a first converter input (3a) intended for receiving a measurement signal having a test frequency to be measured;
a second converter input (3b) connected to the filter output (2b); and
a converter output (3c) adapted for outputting the frequency-converted signal based on the measurement signal as received at the first converter input (3a), by dividing the test frequency by the digital signal as received at the second converter input (3b), said converter output being connected to the second comparator input (1b);
wherein the filter output (2b) is also connected to an output (10) of the digital frequency meter, so that a measurement result of the test frequency is based on the digital signal outputted by the loop-filter (2).

2. Digital frequency meter according to Claim 1, further comprising an averaging module (5), and wherein the filter output (2b) is connected to the output (10) of the digital frequency meter using the averaging module.

3. Digital frequency meter according to Claim 1 or 2, further comprising a splitter (91), a sigma-delta modulator (92) and an adder (93),
wherein the splitter (91) is connected for receiving at input the digital signal from the filter output (2b), and transmitting to the sigma-delta modulator (92) and the adder (93) respectively fractional and integer parts both corresponding to the digital signal,
and the adder (93) is connected for receiving both the integer part and a modulated instant value which is produced by the sigma-delta modulator (92) based on the fractional part of the digital signal, and transmitting a sum result of said integer part and instant value to the second converter input (3b).

4. Digital frequency meter according to any one of Claims 1 to 3, wherein the clock comparator (1) comprises a phase frequency detector and a charge pump unit serially connected,
and the loop filter (2) comprises a resistor (21) and a capacitor (22) serially connected between an output of the charge pump unit and a voltage reference terminal, and further comprises an analog-to-digital converter (24) also connected to the output of the charge pump unit,
so that the analog-to-digital converter (24) produces the digital signal as matching a total voltage existing over both the resistor (21) and the capacitor (22).

5. Digital frequency meter according to any one of Claims 1 to 3, wherein the clock comparator (1) comprises a phase frequency detector and a time-to-digital converter serially connected,
and the loop filter (2) comprises a digital proportional-integral filter.

6. Digital frequency meter according to any one of the preceding claims, comprised within an in-chip circuitry.

7. Digital frequency meter according to any one of the preceding claims, wherein the clock comparator (1), the loop filter (2) and the frequency converter (3) also pertain to a phase-locked loop (PLL) device, and are connected for either operation of the digital frequency meter or PLL operation, in accordance with an operation selection command,
the PLL device itself further comprising:
- an extra loop filter (5) of digital low-pass type, connected at input (5a) to the filter output (2b) of the loop filter (2) of proportional-integral type;
- a digital-to-analog converter (8), connected at input to an output (5b) of the extra loop filter (5); and
- a voltage-controlled oscillator (VCO) (6) having itself:
an analog input (6a) connected for receiving a direct voltage (Vₜᵤₙₑ) produced from the digital-to-analog converter (8); and
a VCO output (6b) adapted for outputting a VCO signal having a frequency which varies as a continuous function of the direct voltage (Vₜᵤₙₑ), and the VCO output being connected to the first converter input (3a) at least for the PLL operation;
and the PLL device being adapted so that during the PLL operation, the connection from the filter output (2b) of the loop filter (2) to the second converter input (3b) is disabled and replaced by an input path adapted for forcing a division factor value at the second converter input.

8. Digital frequency meter according to Claim 7 together with Claim 2, wherein the averaging module (5) is a low-pass filter also pertaining to the PLL device, and connected downstream the loop filter (2) during the PLL operation.

9. Digital frequency meter according to Claim 7 or 8, wherein the VCO output (6b) is connected to the first converter input (3a) also for the digital frequency meter operation, so that the VCO signal forms the measurement signal and the measurement result of said digital frequency meter operation relates to the frequency of said VCO signal,
the digital frequency meter being further adapted for forcing the direct voltage (Vtune) received at the analog input (6a) of the VCO (6) to a constant value, during the digital frequency meter operation.

10. Digital frequency meter according to Claim 9, wherein the VCO (6) is provided with a digitally-controlled capacitor rank (60) suitable for selecting one frequency range based on a code value, among a plurality of frequency ranges available, and the digital frequency meter is further adapted for supplying the capacitor rank with successive code values, respectively for several successive digital frequency meter operations.

11. Method for measuring a test frequency of a measurement signal, comprising the following steps:
/i/ providing a PLL device which comprises at least a clock comparator (1), a loop filter (2) of proportional-integral type and a frequency converter (3), connected for a PLL operation;
/ii/ wiring said clock comparator (1), loop filter (2) and frequency converter (3) so as to form a digital frequency meter in accordance with Claim 1;
/iii/ inputting the measurement signal into the first converter input (3a) so as to obtain a measurement result relating to the test frequency; and
/iv/ re-wiring the clock comparator (1), loop filter (2) and frequency converter (3) back for the PLL operation.

12. Method according to Claim 11, wherein the PLL device further comprises a voltage-controlled oscillator (VCO) (6) having itself:
an analog input (6a) connected for receiving a direct voltage (Vₜᵤₙₑ); and
a VCO output (6b) adapted for outputting a VCO signal having a frequency which varies as a continuous function of the direct voltage;
and wherein during at least step /iii/, the VCO output (6b) is connected to the first converter input (3a) so that the frequency of the VCO signal is the test frequency while the direct voltage (Vₜᵤₙₑ) is forced to a constant value.
